# EUROPEAN PATENT APPLICATION

(11) **EP 0 792 093 A2**
(43) Date of publication of application: **27.08.1997**
(21) Application number: 97300548.1
(22) Date of filing: 29.01.1997
(51) Int. Cl.: H05K 3/32, H01R 4/00

(54) **Dielectric breakdown interconnection**

(30) Priority: 22.02.1996 US 605350
(71) Applicant: SCITEX DIGITAL PRINTING, Inc., Dayton, Ohio 45420-4099 (US)
(72) Inventor: Braun, Hilarion, Phoenix, Arizona 85009 (US)
(74) Representative: Hillier, Peter

(57) **Abstract**

An interconnect method is used for interconnecting a plurality of devices, such as electronic circuits, particularly in situations where flex cables need to be connected to a circuit and where high pitch is necessary, and where interconnect resistance is not critical. In accordance with the interconnect method, an interconnect site is created between the devices to be interconnected; and dielectric breakdown is applied preferentially at the interconnect site. The devices or circuits are interconnected such that the leads are brought into coincidence such that the bonding agent between opposite leads is of minimal thickness relative to the bonding agent or epoxy between adjacent leads.

## Description

### Technical Field

The present invention relates to the field of ink jet printers and, more particularly, to interconnection between devices and/or circuits in ink jet printers where contact resistance is not a critical feature.

### Background Art

In continuous ink jet printing, electrically conductive ink is supplied under pressure to a manifold region that distributes the ink to a plurality of orifices, typically arranged in a linear array(s). The ink discharges from the orifices in filaments which break into droplet streams. Individual droplet streams are selectively charged in the region of the break off from the filaments and charge drops are deflected from their normal trajectories. The deflected drops may be caught and recirculated, and the undeflected drops allowed to proceed to a print receiving medium.

Drops are charged by a charge plate having a plurality of charging electrodes along one edge, and a corresponding plurality of connecting leads along one surface. The edge of the charge plate having the charging electrodes is placed in close proximity to the break off point of the ink jet filaments, and charges applied to the leads to induce charges in the drops as they break off from the filaments.

Usual interconnect schemes that involve flex circuits or cables are accomplished by a variety of means, including soldering, wire binding or tab, and through the use of anisotropically conductive epoxies. Unfortunately, all of these approaches have pitch (i.e., number of interconnects per unit length) limitations, cost concerns, and/or implementation problems relative to existing charge electrode structures. All of these approaches provide a low resistance at the contact site, an attribute not necessary for charge plates because of the very low current and low electrode capacitance.

It is seen then that there is a need for an improved interconnection scheme for use with ink jet printers which overcomes the problems associated with the prior art.

### Summary of the Invention

This need is met by the interconnection technique according to the present invention, wherein interconnection between two devices/circuits where contact resistance is not critical can be accomplished by preferential dielectric breakdown.

In accordance with one aspect of the present invention, an interconnect method is used for interconnecting a plurality of devices, such as electronic circuits, particularly in situations where flex cables need to be connected to a circuit, where high pitch is necessary, and where interconnect resistance is not crucial. In accordance with the interconnect method of the present invention, a bonding agent is provided, typically an adhesive or epoxy. An interconnect site is then created between the devices to be interconnected by the bonding agent. Dielectric breakdown is preferentially caused at the interconnect site through the bonding agent. The devices or circuits are interconnected such that the leads are brought into coincidence and such that the bonding agent between opposite leads is of minimal thickness relative to the bonding agent between adjacent leads.

It is an object of the present invention to provide an improved interconnection technique for interconnecting multiple devices and circuits. It is a further object of the present invention to provide the interconnection by causing dielectric breakdown preferentially at the interconnect site.

Other objects and advantages of the invention will be apparent from the following description and the appended claims.

### Brief Description of the Drawing

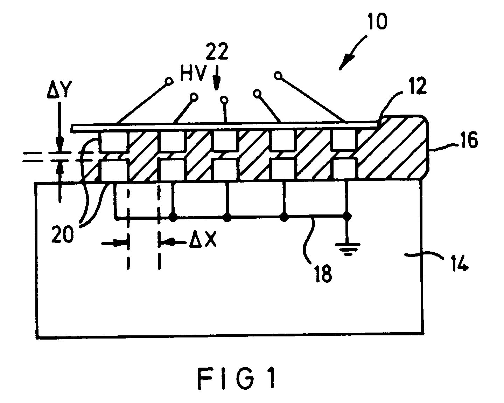

Fig. 1 is a schematic view of a dielectric breakdown interconnection technique, in accordance with the present invention.

### Detailed Description of the Preferred Embodiments

Referring to the drawing, in Fig. 1 there is illustrated a dielectric breakdown interconnect structure 10. The structure 10 comprises a flex cable 12, such as a Kapton cable or similar device, for connecting to a device 14, such as an electronic circuit. A bonding agent 16, such as epoxy, is used to bond the cable 12 to the printed circuit/plate 14. A common ground temporary short bar 18 provides a path to ground. The dielectric breakdown interconnect structure 10 further comprises a plurality of interconnect pairs 20 to be connected. A high voltage switch 22 determines which interconnect pair will be shorted to accomplish the preferential dielectric breakdown.

As will be obvious to those skilled in the art, the devices to be connected may be any combination of cables and/or circuits and/or other devices. The particular devices used herein are for illustration purposes only, and are not to be considered as limiting the scope of the invention.

As can be seen in Fig. 1, two interconnect pairs or contact arrays are bonded face-to-face with a bonding agent or epoxy 16, such that a resultant interconnect pad epoxy thickness is small compared to the distance between interconnects. A current limited high voltage power supply is connected sequentially with the flex cable 12 across all contact pairs 20 to cause an arc to break down the thin layer of epoxy separating the contact pads. The breakdown will cause carbon and, possibly, metallic residues to create a conductive path between the contact pairs. In a preferred embodiment of the present invention, the bonding agent 16 is a hydrocarbon, to provide free carbon for conduction after the breakdown.

Epoxy bonds are generally on the order of 0.005" thick. However, thinner layers are possible, and may even be desirable. For example, if an interconnect pitch of 240/inch is desired, an interlead separation, i.e., the distance between edges of adjacent leads, of 0.002" is possible, if each lead is approximately 0.002" wide. Assuming that the lead thickness on one circuit might be 0.001" and on the other 0.0001", an average epoxy bond thickness of approximately 0.001" would allow a small fraction between lead pairs.

Continuing with the drawing, a value for ▲y depends on epoxy parameters and bonding stress, while a value for ▲x depends on circuit pitch and pad widths. As long as ▲y/▲x < 1, determined by pitch and bonding, any potential difference applied to the pair would cause breakdown in the ▲y region before breakdown would occur in the ▲x region. Once breakdown occurs in the ▲y region, the potential difference between adjacent circuits would drop, preventing any further breakdown. Any continued arcing in the region will enhance the conductivity in that region via carbon and/or metallic sputtering.

### Industrial Applicability and Advantages

The present invention is useful in the field of ink jet printing, and has the advantage of providing an interconnect scheme for connecting two electronic circuits and/or devices. The present invention provides the further advantage of being cost effective, particularly in situations where interconnect resistance is not critical. It is an advantage of the present invention that it is useful when flex cables need to be connected to a circuit where high pitch is necessary and cost control is important.

Having described the invention in detail and by reference to the preferred embodiment thereof, it will be apparent that other modifications and variations are possible without departing from the scope of the invention defined in the appended claims.

## Claims

1. An interconnect method for interconnecting a plurality of devices, comprising the steps of:
providing a bonding agent;
creating an interconnect site between the devices to be interconnected using the bonding agent; and
causing dielectric breakdown preferentially at the interconnect site through the bonding agent.

2. An interconnect method as claimed in claim 1 wherein the step of causing dielectric breakdown preferentially at the interconnect site through the bonding agent creates a breakdown region.

3. An interconnect method as claimed in claim 2 wherein the dielectric breakdown is accompanied by formation of a metallic path through the breakdown region.

4. An interconnect method as claimed in claim 2 wherein the bonding agent comprises a hydrocarbon.

5. An interconnect method as claimed in claim 1 wherein the step of creating an interconnect site further comprises the step of using a flex cable to connect the devices.
